# EUROPÄISCHE PATENTSCHRIFT

(11) **EP 0 599 017 B1**
(45) Veröffentlichungstag und Bekanntmachung des Hinweises auf die Patenterteilung: **30.08.1995**
(21) Anmeldenummer: 93115496.7
(22) Anmeldetag: 25.09.1993
(51) Int. Cl.: H01R 33/46

(54) **Lampenhalterung für eine elektrische Baugruppe**
Lamp holder for an electric assembly
Support de lampe pour un ensemble électrique

(30) Priorität: 19.11.1992 DE 4238928
(43) Veröffentlichungstag der Anmeldung: 01.06.1994
(73) Patentinhaber: Preh-Werke GmbH & Co. KG, 97616 Bad Neustadt (DE)
(72) Erfinder: Bauer, Karl-Heinz, D-97616 Bad Neustadt a.d. Saale (DE); Eckert, Gerold, D-97616 Bad Neustadt a.d. Saale (DE)

(56) Entgegenhaltungen:
- DE-A- 1 589 314
- DE-A- 3 605 209
- DE-C- 4 019 495

## Beschreibung

Die Erfindung betrifft eine Lampenhalterung für eine elektrische Baugruppe, wobei die Baugruppe wenigstens aus einer Leiterplatte, einem mechanischen Bauteil und einer mit der Leiterplatte direkt kontaktierenden Lampe besteht, gemäß dem Oberbegriff des Anspruches 1.

Baugruppen der bezeichneten Art sind beispielsweise aus der DE 42 36 353 bekannt. Man findet derartige Baugruppen in elektrischen Geräten bei denen Bedien- und Anzeigeflächen der Gerätewandung auszuleuchten sind. Oftmals sind derartige Bedien- oder Anzeigeflächen z.B. als Tastschalter oder als Flüssigkristalldisplay selbst Teil der Baugruppe und werden über deren Leiterplatte elektrisch versorgt.

Elektrische Baugruppen sind häufig mit mechanischen Bauteilen ausgestattet, diese sind entsprechend ihrer Aufgabe unterschiedlich gestaltet. Solche Bauteile sind aus Kunststoff (DE 32 47 531 A1) oder aus Metall (BE 881 912); sie bilden abschnittsweise Wandungen aus, die zumindest in Teilbereichen beabstandet parallel zur Leiterplatte der eigenen Baugruppe verlaufen. Das mechanische Bauteil versteift zum einen die Baugruppe und erleichtert deren separates Handling. Aus Blech dient es außerdem der Abschirmung von thermischer oder elektrischer Strahlung. Eine solche Baugruppe ist beispielsweise an Autoradios zu finden. Dort kann die Baugruppe mit dem zugehörigen Gehäuseteil vom Gerät entfernt werden, um einen Diebstahl des Gerätes zu erschweren. Ein mechanisches Bauteil aus Kunststoff findet man beispielsweise in Baugruppen, die keine elektrische Abschirmung erfordern, deren Montage oder Weiterverwendung sich jedoch durch ein speziell geformtes Bauteil vereinfachen lassen. Mitunter wird ein solches Bauteil als eine Art Rahmen oder als Gehäuse benutzt, in dem Einzelteile einer Baugruppe eingebracht und gehalten sind.

Mit Anschlußdrähten ausgestattete Lampen sind handelsüblich, z.B. Glühlampe 7012 der Fa. ALBA, Bamberg. Die Anschlußdrähte solcher Lampen können direkt mit der Leiterplatte verlötet sein. Häufiger werden, z.B. um den Austausch defekter Lampen zu vereinfachen, Lampenfassungen verwendet. Eine Lampenfassung kontaktiert eine Lampe lösbar an der Leiterplatte und sie hält bedarfsweise eine Lampe ausgerichtet, z.B. auf einen Lichtleiter. Die Kontaktsicherheit einer lösbaren Kontaktierung ist vom Kontaktdruck beeinflußt. Um einen Kontaktdruck alterungsbeständig zu erzeugen, sind Federelemente vonnöten. Die Federelemente herkömmlicher Lampenfassungen sind zumeist aufwendig gestaltete Zwischenkontakte, die zusätzlich in eine Lampenfassung eingebracht zugleich die Anschlußdrähte einer Lampe elektrisch mit einer Leiterplatte verbinden. In der DT 22 50 007 C3 ist ein solcher Zwischenkontakt als Kelchfeder gezeigt. In der DE 87 11 882 U1 ist eine selbsthaltend einsetzbare LED-Fassung dargestellt, deren Zwischenkontakt teilweise erst in Gebrauchslage als Federelement wirkt.

Eine an einer Leiterplatte gehaltene Lampenfassung, bei der die Anschlußdrähte der Lampe an der Lampenfassung geführt unmittelbar mit der Leiterplatte unter Kontaktdruck kontaktieren, ist aus der DE 40 19 495 C1 bekannt. Hierbei fehlt ein federelastischer Zwischenkontakt; der erforderliche Kontaktdruck wird im wesentlichen durch Verformung des freigestellten Anschlußdrahtes der Lampe erzeugt. Ein solcher Anschlußdraht ist nur wenig elastisch, die erzeugte Kontaktierung ist deshalb nur begrenzt alterungsbeständig.

Aus der DE 74 13 766 U1 ist bereits eine Lampenhalterung für eine Leiterplatte bekannt, mit einer Lampenfassung die eine parallel zur Fläche der Leiterplatte verlaufende Wandung ausbildet. Dabei werden die Anschlußdrähte einer von der Lampenfassung gehaltenen Lampe mittels der Wandung direkt an der Leiterplatte kontaktiert, wobei ein Kontaktdruck dadurch erzeugt wird, daß die Leiterplatte und die Anschlußdrähte zwischen der freigestellten, in Grenzen federnden Wandung und den zur Halterung an der Lampenfassung ausgebildeten Rastnasen eingespannt sind.

Weiterhin ist aus der DE-OS 15 89 314 eine Lampenfassung bekannt, die bajonettverschlußartig in einer Leiterplatte einsetzbar ist. Die Lampenfassung hat in Einsteckrichtung versetzt angeordnete Anschläge, zwischen die die Leiterplatte und die Anschlußdrähte einer Lampe beim Einsetzen eingeklemmt werden. Ein Federelement zur Kontaktsicherung fehlt.

Es ist Aufgabe der Erfindung für eine elektrische Baugruppe der eingangs bezeichneten Art unter Ausnutzung vorhandener Baulemente eine Lampenhalterung für eine auszuwechselbare Lampe anzugeben, die über lange Zeiträume eine hohe Kontaktsicherheit aufweist und dennoch einfach aufgebaut ist. Die Aufgabe ist dadurch gelöst, daß die Lampe (4) in einer Lampenfassung (3) steckt, welche die Anschlußdrähte (16) zur Leiterplatte (1) führt und kontaktiert, daß die Lampenfassung (3) wenigstens zwei in Richtung ihrer Längsachse (8) versetzt angeordnete Anschläge (9,10) aufweist, und daß Leiterplatte (1) und Wandung (2) miteinander fluchtende Montageöffnungen (6,7) aufweisen, in welche die Lampenfassung in Richtung ihrer Längsseite (8) bajonettverschlußartig eingesetzt und gehalten ist, wobei die Anschläge (9,10) unter Einklemmen der Anschlußdrähte die Leiterplatte (1) und die federnd nachgebende Wandung (2) gegenseitig verspannen.

Der zur Sicherung der Kontaktierung von Anschlußdraht und Leiterplatte über lange Zeiträume hinweg bleibende Kontaktdruck ist durch die federnde Wandung erzeugt, die kraftschlüssig mit der Lampenfassung verbunden ist. Die Fläche der freiliegenden Wandung ist durch Druck mit einfachen Mitteln verspannbar. Eine derart verspannte Wandung stellt einen elastischen Kraftspeicher dar, der erfindungsgemäß für den Kontaktdruck der Kontaktierung genutzt wird. Zusätzliche Maßnahmen zur Sicherung der Lampenkontaktierung können entfallen.

In einer Ausgestaltung der Erfindung wird die Wandung zur Leiterplatte hin verspannt. In einer anderen Ausgestaltung entgegengesetzt, wobei der Anschlußdraht und die Anschläge sich zwischen den beabstandet gehaltenen Wandung und Leiterplatte befinden. In der Regel sind der Anschlußdraht der Lampe, die Leiterplatte und die an der Leiterplatte beispielsweise durch Sicken auf elastischen Abstand gehaltende Wandung zwischen den Anschlägen der Lampenfassung eingespannt. Eine solche Anordnung bringt eine sichere, stabile Kontaktierung der Lampe und hält in vorteilhafter Weise auch noch das Abschirmblech ohne weiteres Zutun an der Leiterplatte. Weitere vorteilhafte Ausgestaltungen der Erfindung sind den Unteransprüchen zu entnehmen.

In nachstehenden Ausführungsbeispielen ist die Erfindung anhand von Zeichnungen näher erläutert. Es zeigen:
- Figur 1: eine geschnittene Teilansicht einer elektrischen Baugruppe mit einer erfindungsgemäßen Lampenhalterung,
- Figur 2: die Lampenfassung aus Figur 1 in Draufsicht,
- Figur 3: die Lampenfassung aus Figur 1 geschnitten längs der Linie A-A dargestellt,
- Figur 4: die Montageöffnung des Abschirmbleches aus Figur 1, vergrößert dargestellt,
- Figur 5: eine zu Figur 1 alternative Abstandshalterung des Abschirmbleches im Schnitt B-B, schematisiert dargestellt

und
- Figur 6: die Montageöffnung des Abschirmbleches aus Figur 5.

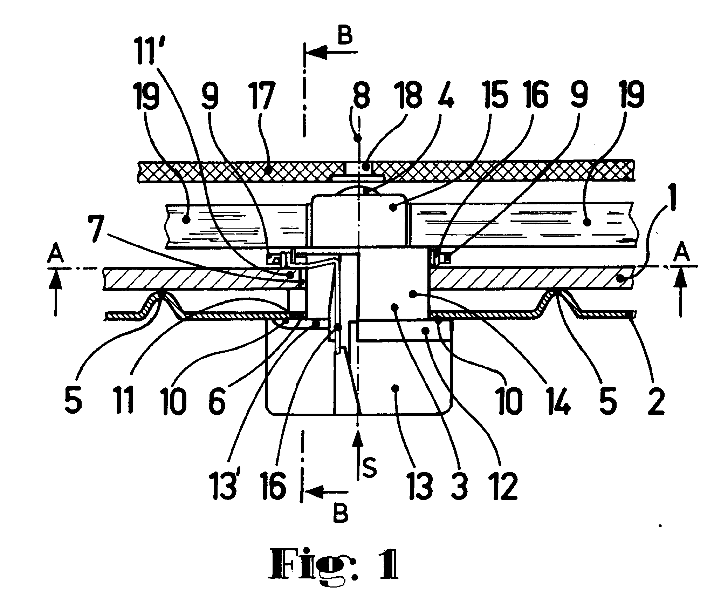

Figur 1 zeigt eine geschnittene Teilansicht einer elektrischen Baugruppe mit einer erfindungsgemäßen Lampenhalterung in Gebrauchslage. Die elekttrische Baugruppe enthält in gegenseitiger Zuordnung eine Leiterplatte(1), ein Abschirmblech (2) und eine Lampenfassung (3) mit Lampe (4). Das Abschirmblech(2) stellt im Ausführungsbeispiel die Wandung(2) der Erfindung dar. Die Leiterplatte (1) ist mit einer nicht dargestellten Schaltung versehen, deren Leitungszüge und Kontaktflächen mögliche elektrische Bauelemente der Baugruppe elektrisch versorgen. Das Abschirmblech (2) ist im wesentlichen parallel zur Leiterplatte (1) verlaufend durch Sicken (5) auf Abstand gehalten. Die Fläche des Abschirmbleches (2) zwischen den Sicken (5) hat eine drehsymmetrisch gestaltete Öffnung (6) gemäß Figur 4. Die Leiterplatte (1) besitzt eine in gleicher Weise geformte Öffnung (7), die mit der Öffnung (6) des Abschirmbleches fluchtet. In die Öffnungen (6, 7) ist die Lampenfassung (3) bajonettverschlußartig durch Einstecken und nachfolgendes Drehen in Richtung des Pfeiles **R** eingesetzt. Die Lampenfassung ist bezüglich ihrer Längsachse (8) drehsymmetrisch gestaltet; die angeformten Anschläge (9,10) sind dementsprechend paarweise vorhanden. Die Anschlag-Paare sind in Einsteckrichtung **S** gegenseitig versetzt angeordnet. Leiterplatte (1) und Abschirmblech (2) bilden Zungen (11, 11') aus, mit denen sie in die Fläche ihrer Öffnung (6, 7) hineinragen. In Einbaulage liegen die Anschläge (9, 10) an den Zungen (11, 11') an und schließen Leiterplatte (1) und Abschirmblech (2) zwischen sich ein. Dabei wird die Zunge (11) des Abschirmbleches (2) gegen die Leiterplatte (1) gespannt. Die Abschirmblech-seitigen Anschläge (10) der Lampenfassung (3) sind durch lappenförmige Ansätze (12) verbreitert, diese verhindern ein Durchstecken der Lampenfassung (3) durch die Öffnungen (6, 7). Ein entgegen der Einsteckrichtung **S** an der Lampenfassung (3) vorstehendes Griffteil (13) erleichtert das Einsetzen der Lampenfassung in die elektrische Baugruppe. Am Griffteil befindet sich eine Einführschräge (13') in Höhe des Anschlages (10). Die Lampe (4) ist in den Lampenkörper (14) der Lampenfassung eingesteckt. Am Lampenkörper (14) ist eine rohrförmige Verlängerung (15) angeformt, die den Kopf der Lampe (4) umringt. Die Verlängerung (15) ist stirnseitig offen. Die Anschlußdrähte (16) der Lampe (4) sind am Lampenkörper (14) jeweils zu einem der Leiterplatte-seitigen Anschläge (9) geführt. Der Anschlußdraht (16) ist dort um den Anschlag (9) gewendelt und mit diesem unter Kontaktdruck gegen eine in der Darstellung nicht erkennbare Kontaktfläche der Leiterplatte gedrückt. Der Kontaktdruck wird von den gespannten Zungen (11) des Abschirmbleches (2) an der Lampenfassung (3) erzeugt und von der Lampenfassung auf die Kontaktstelle an der Zunge (11') der Leiterplatte übertragen. Die gesamte elektrische Baugruppe ist von einer Gerätewandung (17) überdeckt. Die Gerätewandung (17) enthält eine transparente Anzeigefläche (18) oberhalb der Lampe (4). Die rohrartige Verlängerung (15) des Lampenkörpers (14) ist in einen Lichtleiter (19) eingesteckt. Bei transluzent eingefärbter Lampenfassung (3) bestrahlt die Lampe (4) den Lichtleiter (19) in der Lichtfarbe der Lampenfassung und die Anzeigefläche (18) in der Lichtfarbe der Lampe (4).

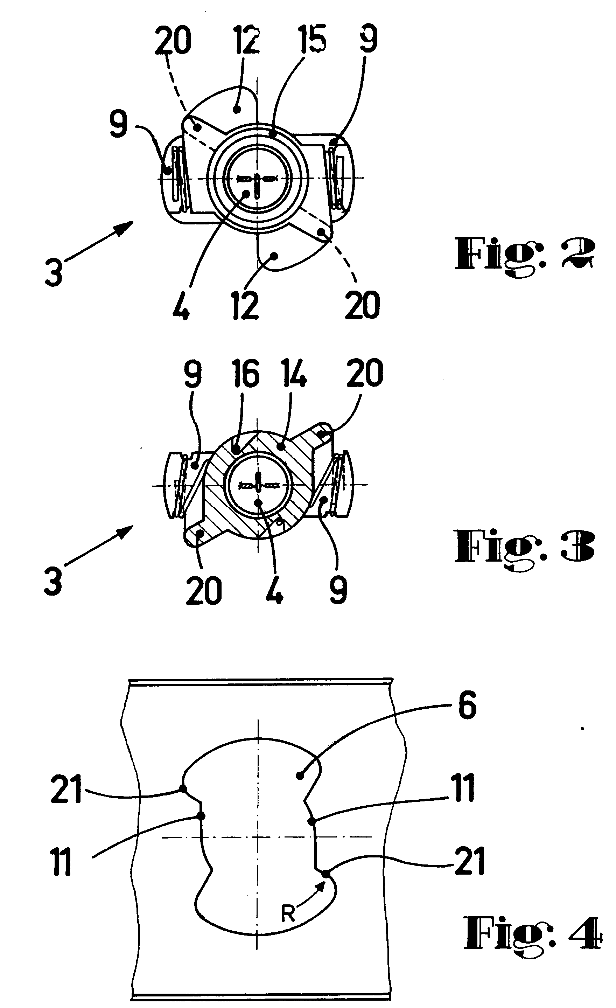

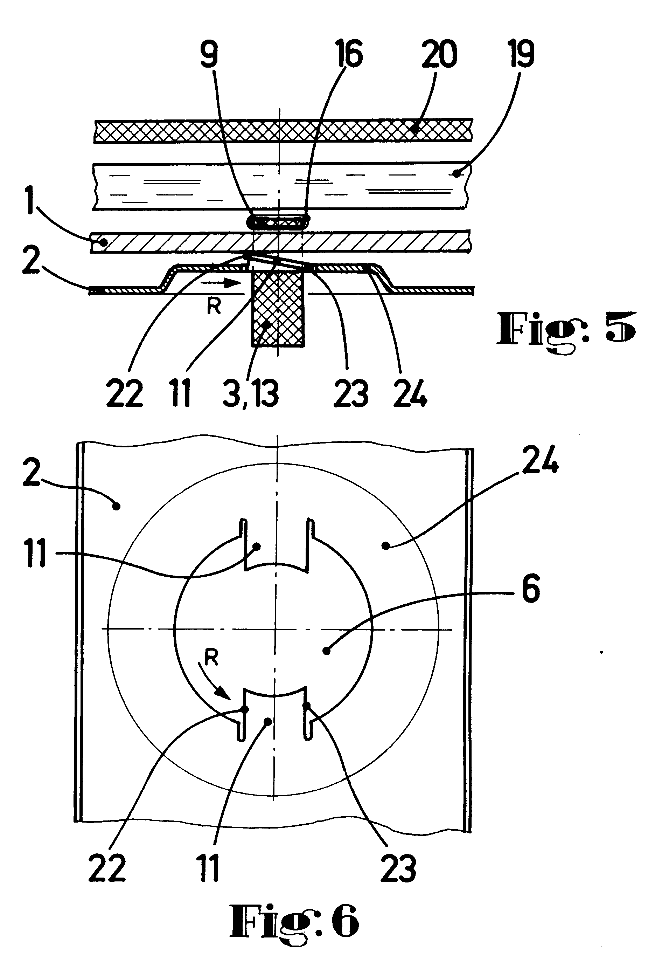

Figur 2 ist eine Draufsicht auf die rohrförmige Verlängerung (15) der Lampenfassung. Es ist die eingesetzte Lampe (4) zu erkennen, sowie an der Kontur der Lampenfassung die Ausgestaltung des Ansatzes (12), der ein Durchstecken durch die Öffnung (6, 7) verhindert. In Figur 3 blickt man auf die zur Leiterplatte gerichtete Kontaktseite der Anschläge (9). Der geschnitten dargestellte Lampenkörper (14) zeigt nach außen gerichtete Wandungen (20), die dazu vorgesehen sind, das Drehen der Lampenfassung (3) in Richtung **R** beim Einsetzen in die Baugruppe zu begrenzen. Die Wandung (20) schlägt an der Öffnungskante (21) an (Figur 4).

In den Figuren 5, 6 ist eine alternative Spannhalterung der Lampenfassung dargestellt. Die stärker freigeschnittenen Zungen (11) des Abschirmbleches (2) sind quer geschrägt. Die geschrägte Zunge (11) stützt sich dabei mit ihrer einen Zungenseite (22) gegen die Leiterplatte (1) und mit ihrer anderen Zungenseite (23) gegen die Lampenfassung (3). Infolge der gewählten Lage der Schnittlinie in Figur 1 ist die Lampenfassung (3) in Figur 5 nur unvollständig gezeigt. Erkennbar sind das geschnittene Griffteil (13) und der geschnittene Anschlag (9) mit dem gewendelten Anschlußdraht (16). Das Abschirmblech ist in der Umgebung der Öffnung (6) mit einer Teilfläche (24) gegen die Leiterplatte (1) geprägt. Dadurch ist bereits mit geringer Schrägstellung der Zunge (11) Abstand und Andruckkraft zu erbringen.

Bei den beschriebenen Ausführungsbeispielen schließen die Anschläge (9, 10) der Lampenfassung (3) die Leiterplatte (1) und das Abschirmblech (2) zwischen sich ein. Eine solche Anordnung ist günstig, wenn die Kontaktflächen sich auf der Außenseite der Leiterplatte (1) befinden. Befinden sich die Kontaktflächen für die Lampenfassung (3) auf der Innenseite der Leiterplatte, d.h. auf der Wandungsseite, dann ist der Aufbau der Baugruppe so zu gestalten, daß die Leiterplatte (1) und das Abschirmblech (2) die Anschläge (9, 10) der Lampenfassung (3) zwischen sich einschließen.

### Bezugszeichenliste 03/92 Pt.

- 1: Leiterplatte
- 2: Abschirmblech, Wandung
- 3: Lampenfassung
- 4: Lampe
- 5: Sicke
- 6: Öffnung
- 7: Öffnung
- 8: Längsachse
- 9: Anschlag
- 10: Anschlag
- 11,11′: Zunge
- 12: Ansatz
- 13: Griffteil
- 13′: Einführschräge
- 14: Lampenkörper
- 15: Verlängerung
- 16: Anschlußdraht
- 17: Gerätewandung
- 18: Anzeigefläche
- 19: Lichtleiter
- 20: Wandung
- 21: Öffnungskante
- 22: Zungenseite
- 23: Zungenseite
- 24: Teilfläche

- R: Drehrichtung
- S: Einsteckrichtung

## Patentansprüche

1. Lampenhalterung für eine elektrische Baugruppe, wobei letztere wenigstens aus einer Leiterplatte (1), einem mechanischen Bauteil und einer Lampe (4) besteht, und wobei die Anschlußdrähte (16) der Lampe (4) die Leiterplatte (1) direkt kontaktieren und das mechanische Bauteil eine Wandung (2) aufweist die parallel beabstandet zur Fläche der Leiterplatte gehalten ist,
dadurch gekennzeichnet,
daß die Lampe (4) in einer Lampenfassung (3) steckt, welche die Anschlußdrähte (16) zur Leiterplatte (1) führt und kontaktiert, daß die Lampenfassung (3) wenigstens zwei in Richtung ihrer Längsachse (8) versetzt angeordnete Anschläge (9, 10) aufweist,
und daß Leiterplatte (1) und Wandung (2) miteinander fluchtende Montageöffnungen (6, 7) aufweisen, in welche die Lampenfassung in Richtung ihrer Längsachse (8) bajonettverschlußartig eingesetzt und gehalten ist, wobei die Anschläge (9, 10) unter Einklemmen der Anschlußdrähte die Leiterplatte (1) und die federnd nachgebende Wandung (2) gegenseitig verspannen.

2. Lampenhalterung nach Anspruch 1,
dadurch gekennzeichnet,
daß die Anschläge (9, 10) die Leiterplatte (1) die Wandung (2) und die Anschlußdrähte (16) zwischen sich einspannen.

3. Lampenhalterung nach Anspruch 1,
dadurch gekennzeichnet,
daß die Anschläge (9, 10) die Leiterplatte (1) und die Wandung (2) unter Einklemmen der Anschlußdrähte (16) spreizen.

4. Lampenhalterung nach Anspruch 1 oder 2,
dadurch gekennzeichnet,
daß die Leiterplatte (1) und die Wandung (2) jeweils wenigstens eine in die jeweilige Montageöffnung (6, 7) hineinragende, mit dem entsprechenden Anschlag (9, 10) korrespondierende Zunge (11, 11') aufweisen.

5. Lampenhalterung nach Anspruch 4,
dadurch gekennzeichnet,
daß die Zunge (11) der Wandung (2) quer geschrägt ist, wobei sich eine Zungenseite (22) an der Leiterplatte (1) und die andere Zungenseite (23) am Anschlag (9, 10) abstützen.

6. Lampenhalterung nach einem der Ansprüche 1, 2, 4 oder 5
dadurch gekennzeichnet,
daß sich die Wandung (2) durch Abstand bildende Einrichtungen (5, 22) gegen die Leiterplatte abstützt.

7. Lampenhalterung nach einem der Ansprüche 1 bis 6,
dadurch gekennzeichnet,
daß die Lampenfassung (3) ein Griffteil (13) aufweist.

8. Lampenhalterung nach einem der Ansprüche 1 bis 7,
dadurch gekennzeichnet,
daß das mechanische Bauteil ein Blechtei ist.

9. Lampenhalterung nach einem der Ansprüche 1 bis 7,
dadurch gekennzeichnet,
daß das mechanische Bauteil aus Kunststoff erstellt ist.

10. Lampenhalterung nach einem der Ansprüche 1 bis 9,
dadurch gekennzeichnet,
daß jeweils ein Anschlußdraht (16) um einen der Anschläge (9, 10) gewendelt ist und daß beide Anschlußdrähte (16) mit ihrem Anschlag (9, 10) an der Leiterplatte (1) anliegen.

11. Lampenhalterung nach Anspruch 8,
dadurch gekennzeichnet,
daß jeweils ein Anschlußdraht (16) um einen der Anschläge (9, 10) gewendelt ist und ein Anschlußdraht (16) mit seinem Anschlag (9, 10) an der Leiterplatte (1) und der andere Anschlußdraht (16) mit seinem Anschlag (9, 10) an der Wandung (2) anliegt.

12. Lampenhalterung nach einem der Ansprüche 1 bis 11,
dadurch gekennzeichnet,
daß die Lampenfassung (3) aus durchsichtigem oder durchscheinendem Material besteht.

## Claims

1. Lamp holder for an electrical assembly, the latter comprising at least a conductor plate (1), a mechanical component and a lamp (4), the terminal wires (16) of the lamp (4) directly contacting the conductor plate (1), and the mechanical component having a wall (2) which is kept at a distance from, and parallel to, the surface of the conductor plate, characterised in that the lamp (4) is inserted in a lamp socket (3) which leads the terminal wires (16) to the conductor plate (10) and makes contact, in that the lamp socket (3) has at least two stops (9, 10) arranged to be offset in the direction of their longitudinal axis (8), and in that the conductor plate (1) and wall have mounting apertures (6, 7) in alignment with each other into which the lamp socket is inserted and retained with a bayonet-type catch in the direction of its longitudinal axis (8), the stops (9, 10) bracing the conductor plate (1) and the resiliently yielding wall (2) against each other, clamping the terminal wires.

2. Lamp holder according to claim 1, characterised in that the stops (9, 10) clamp the conductor plate (1), the wall (2) and the terminal wires (16) between them.

3. Lamp holder according to claim 1, characterised in that the stops (9, 10) spread the conductor plate (1) and the wall (2) apart, clamping the terminal wires (16).

4. Lamp holder according to claim 1 or 2, characterised in that the conductor plate (1) and the wall (2) respectively have at least one tongue (11, 11′) protruding into the respective mounting aperture (6, 7) and in correspondence with the corresponding stop (9, 10).

5. Lamp holder according to claim 4, characterised in that the tongue (11) of the wall (2) is inclined transversely, one side (22) of the tongue being supported on the conductor plate (1) and the other side of the tongue (23) on the stop (9, 10).

6. Lamp holder according to one of claims 1, 2, 4 or 5, characterised in that the wall (2) is supported against the conductor plate by devices (5, 22) forming a spacing.

7. Lamp holder according to one of claims 1 to 6, characterised in that the lamp socket (3) has a gripping portion (13).

8. Lamp holder according to one of claims 1 to 7, characterised in that the mechanical component is a piece of sheet metal.

9. Lamp holder according to one of claims 1 to 7, characterised in that the mechanical component is made of plastics.

10. Lamp holder according to one of claims 1 to 9, characterised in that one terminal wire (16) is respectively coiled round one of the stops (9, 10) and in that both terminal wires (16) abut the conductor plate (1) with their stop (9, 10).

11. Lamp holder according to claim 8, characterised in that a terminal wire (16) is respectively coiled round each one of the stops (9, 10), one terminal wire (16) abutting the conductor plate (1) with its stop (9, 10) and the other terminal wire (16) abutting the wall (2) with its stop (9, 10).

12. Lamp holder according to one of claims 1 to 11, characterised in that the lamp socket (3) is made of transparent or translucent material.

## Revendications

1. Support d'ampoule pour ensemble électrique, ce dernier étant constitué au moins d'une plaquette de circuit imprimé (1), d'une pièce constitutive mécanique et d'une ampoule (4), et les fils de branchement (16) de l'ampoule (4) étant directement en contact avec la plaquette de circuit imprimé (1) et la pièce constitutive mécanique présentant une paroi (2) qui est maintenue parallèle et à distance de la plaquette de circuit imprimé, support caractérisé en ce que l'ampoule (4) est enfichée dans une monture (3) d'ampoule, qui conduit les fils de branchement (16) jusqu'à la plaquette de circuit imprimé (1) et qui les met en contact avec celle-ci ; en ce que la monture (3) d'ampoule présente au moins deux butées (9, 10) décalées dans la direction de son axe longitudinal (8), et en ce que la plaquette de circuit imprimé (1) et la paroi (2) présentent des ouvertures de montage (6, 7) en alignement mutuel dans lesquelles la monture d'ampoule est mise en place à la façon d'une monture à baïonnette dans son sens longitudinal (8) et y est maintenue, les butées (9, 10) maintenant serrées l'une contre l'autre la plaquette de circuit imprimé (1) et la paroi (2) qui cède élastiquement, en bloquant les fils de branchement.

2. Support d'ampoule selon la revendication 1, caractérisé en ce que les butées (9, 10) maintiennent entre elles la plaquette de circuit imprimé (1), la paroi (2) et les fils de branchement (16).

3. Support d'ampoule selon la revendication 1, caractérisé en ce que les butées (9, 10) écartent l'une de l'autre la plaquette de circuit imprimé (1) et la paroi (2), tout en enserrant les fils de branchement (16).

4. Support d'ampoule selon la revendication 1 ou 2, caractérisé en ce que la plaquette de circuit imprimé (1) et la paroi (2) présentent chacune au moins une languette (11, 11′) qui pénètre dans l'ouverture de montage (6, 7) considérée et qui correspond à la butée afférente (9,10).

5. Support d'ampoule selon la revendication 4, caractérisé en ce que la languette (11) de la paroi (2) est disposée inclinée transversalement, un côté (22) de la languette s'appuyant contre la plaquette de circuit imprimé (1) et l'autre côté (23) de la languette s'appuyant contre la butée (9, 10).

6. Support d'ampoule selon l'une des revendications 1, 2, 4 ou 5, caractérisé en ce que la paroi (2) s'appuie contre la plaquette de circuit imprimé, par des dispositifs (5, 22) qui créent un écart.

7. Support d'ampoule selon une des revendications 1 à 6, caractérisé en ce que la monture (3) d'ampoule présente une pièce (13) de saisie ou de préhension.

8. Support d'ampoule selon l'une des revendications 1 à 7, caractérisé en ce que la pièce constitutive mécanique est une pièce en tôle.

9. Support d'ampoule selon l'une des revendications 1 à 7, caractérisé en ce que la pièce constitutive mécanique est réalisée en de la matière plastique.

10. Support d'ampoule selon l'une des revendications 1 à 9, caractérisé en ce que chacun des fils de branchement (16) est enroulé autour de l'une des butées (9, 10) et en ce que les deux fils de branchement (16) sont en appui avec leur butée (9, 10) contre la plaquette de circuit imprimé (1).

11. Support d'ampoule selon la revendication 8, caractérisé en ce que chacun des fils de branchement (16) est enroulé autour de l'une des butées (9, 10) et en ce qu'un fil de branchement (16) est en appui, avec sa butée (9, 10), contre la plaquette de circuit imprimé (1) et que l'autre fil de branchement (16) est en appui avec sa butée (9, 10) contre la paroi (2).

12. Support d'ampoule selon l'une des revendications 1 à 11, caractérisé en ce que la monture (3) d'ampoule est constituée d'un matériau transparent ou translucide.
